# EUROPEAN PATENT APPLICATION

(11) **EP 3 846 230 A1**
(43) Date of publication of application: **07.07.2021**
(21) Application number: 19855626.8
(22) Date of filing: 30.08.2019
(51) Int. Cl.: H01L 33/50, F21V 7/30, F21V 9/45, F21W 131/305, F21W 131/40, F21W 131/405, F21Y 115/10

(54) **LIGHT EMISSION DEVICE, ILLUMINATION DEVICE, AND GRIPPING UNIT**

(30) Priority: 30.08.2018 JP 2018161704; 28.11.2018 JP 2018222335
(71) Applicant: Kyocera Corporation, Kyoto-shi, Kyoto 612-8501 (JP)
(72) Inventor: KATOU, Hidetaka, Kyoto-shi, Kyoto 612-8501 (JP); KUSANO, Tamio, Kyoto-shi, Kyoto 612-8501 (JP); IKEDA, Kouhei, Kyoto-shi, Kyoto 612-8501 (JP); KIMURA, Takayuki, Kyoto-shi, Kyoto 612-8501 (JP); ANDO, Yoshiki, Kyoto-shi, Kyoto 612-8501 (JP); NIZUKA, Takeshi, Kyoto-shi, Kyoto 612-8501 (JP)
(74) Representative: Viering, Jentschura & Partner mbB Patent- und Rechtsanwälte
(86) International application number: PCT/JP2019/034271
(87) International publication number: WO 2020/045665

(57) **Abstract**

A light emitting apparatus includes a light emitting element configured to emit light specified by a spectrum having a peak wavelength in a wavelength range from 360 nm to 430 nm, and a wavelength conversion member configured to convert at least a portion of light emitted by the light emitting element into light specified by a spectrum having a peak wavelength in a wavelength range from 360 nm to 780 nm. The light emitting apparatus emits illumination light formed by a combination of light that is not converted by the wavelength conversion member, from among light emitted by the light emitting element, and light that is converted by the wavelength conversion member. A total energy of light having a wavelength included in the wavelength range from 360 to 430 nm is between 3% and 18% of a total energy of light having a wavelength included in the wavelength range from 360 nm to 780 nm.

## Description

### CROSS REFERENCE TO RELATED APPLICATIONS

This application claims priority to and the benefit of Japanese Patent Applications No. 2018-161704 (filed on August 30, 2018) and No. 2018-222335 (filed on November 28, 2018), the entire contents of which are incorporated herein by reference.

### TECHNICAL FIELD

The present disclosure relates to a light emitting apparatus, a lighting apparatus, and a gripping unit.

### BACKGROUND

Conventionally, a lighting apparatus that includes a semiconductor light emitting element configured to emit ultraviolet rays having a sterilizing and purifying effect and a fluorescent body configured to absorb ultraviolet rays emitted by the semiconductor light emitting element and emit secondary light having a wavelength longer than that of the ultraviolet rays is known (e.g., see PTL 1 set forth below). Realization of an antibacterial effect while suppressing an influence on a user is desired.

### CITATION LIST

### Patent Literature

PTL 1: JP-11-87770 A

### SUMMARY

A light emitting apparatus according to an embodiment of the present disclosure includes a light emitting element and a wavelength conversion member. The light emitting apparatus is configured to emit light specified by a spectrum having a peak wavelength in a wavelength range from 360 nm to 430 nm. The wavelength conversion member is configured to convert at least a portion of light emitted by the light emitting element into light specified by a spectrum having a peak wavelength in a wavelength range from 360 nm to 780 nm. The light emitting apparatus emits illumination light formed by a combination of light that is not converted by the wavelength conversion member, from among light emitted by the light emitting element, and light that is converted by the wavelength conversion member. A total energy of light having a wavelength included in the wavelength range from 360 nm to 430 nm in illumination light is between 3% and 18% of a total energy of light having a wavelength included in the wavelength range from 360 nm to 780 nm.

A lighting apparatus according to an embodiment of the present disclosure includes a plurality of light emitting apparatuses. Each of the plurality of light emitting apparatuses includes a light emitting element and a wavelength conversion member. The light emitting element is configured to emit light specified by a spectrum having a peak wavelength in a wavelength range from 360 nm to 430 nm. The wavelength conversion member is configured to convert at least a portion of light emitted by the light emitting element into light specified by a spectrum having a peak wavelength in a wavelength range from 360 nm to 780 nm. The lighting apparatus is configured to emit illumination light formed by a combination of light that is not converted by the wavelength conversion member, from among light emitted by the light emitting element, and light that is converted by the wavelength conversion member. A total energy of light having a wavelength included in the wavelength range from 360 nm to 430 nm in illumination light is between 3 % and 18% of a total energy of light having a wavelength included in the wavelength range from 360 nm to 780 nm.

A gripping unit according to an embodiment of the present disclosure includes a gripping portion to be gripped by a user and a light emitting apparatus. The light emitting apparatus is configured to emit light specified by a spectrum having a peak wavelength in a wavelength range from 360 nm to 430 nm.

### BRIEF DESCRIPTION OF THE DRAWINGS

In the accompanying drawings:
FIG. 1 is an external perspective view illustrating a light emitting apparatus according to an embodiment;
FIG. 2 is a cross-sectional view of the light emitting apparatus illustrated in FIG. 1 taken along a plane indicated by a virtual line;
FIG. 3 is an enlarged view of a circled portion X illustrated in FIG. 2;
FIG. 4 is a graph illustrating an example of a spectrum of illumination light;
FIG. 5 is a graph illustrating an example of the spectrum of illumination light;
FIG. 6 is an external perspective view illustrating a lighting apparatus that includes the light emitting apparatus according to the embodiment;
FIG. 7 is an exploded perspective view of the lighting apparatus illustrated in FIG. 6;
FIG. 8 is an exploded perspective view of a housing and a light transmitting substrate of the lighting apparatus illustrated in FIG. 6;
FIG. 9 is a graph illustrating an antibacterial effect realized by illumination light emitted by the light emitting apparatus or the lighting apparatus according to the embodiment;
FIG. 10A is a graph illustrating an example of an emission spectrum of a white LED having a peak wavelength of excitation light at 405 nm (violet) and a relative light intensity at 405 nm that is standard;
FIG. 10B is a graph illustrating an example of an emission spectrum of a white LED having a peak wavelength of excitation light at 405 nm (violet) and a relative light intensity at 405 nm that is moderately increased;
FIG. 10C is a graph illustrating an example of an emission spectrum of a white LED having a peak wavelength of excitation light at 405 nm (violet) and a relative light intensity at 405 nm that is increased to a maximum output according to a specification of the apparatus;
FIG. 10D is a graph illustrating an example of an emission spectrum of a white LED having a peak wavelength of excitation light at 415 nm (violet);
FIG. 10E is a graph illustrating an example of an emission spectrum of a white LED having a peak wavelength of excitation light at 450 nm (blue);
FIG. 11 is a graph illustrating a relationship between a length of a light irradiation time and a live cell count of MRSA;
FIG. 12 is a graph illustrating an example of a spectrum of light irradiated to cells in another example test;
FIG. 13 is a graph illustrating a relationship between the length of a light irradiation time and the live cell count of MRSA in another example test;
FIG. 14 is a diagram illustrating a doorknob as an example of a gripping unit;
FIG. 15 is a diagram illustrating a handrail as an example of the gripping unit;
FIG. 16 is a diagram illustrating an umbrella as an example of the gripping unit; and
FIG. 17 is a diagram illustrating a floor as an example of the gripping unit.

### DETAILED DESCRIPTION

In recent years, a lighting apparatus may use a semiconductor light emitting element such as an LED (Light Emitting Diode) as a light source, rather than using a fluorescent lamp or a light bulb. The semiconductor light emitting element may be used as a light source of a lighting apparatus used for an inspection of, for example, the appearance of a painted surface of a home electric appliance or a passenger car.

Generally, a wavelength band of light emitted by a semiconductor light emitting element is narrow. Thus, the semiconductor light emitting element emits light of a single color. A lighting apparatus using the semiconductor light emitting element as a light source includes a plurality of semiconductor light emitting elements, to emit white light as illumination light. In this case, white light is realized by varying wavelength bands of light emitted by the semiconductor light emitting elements and mixing light emitted by the semiconductor light emitting elements. Alternatively, a lighting apparatus includes a plurality of fluorescent bodies that fluoresce in different wavelength bands based on excitation light having the same wavelength. In this case, white light is realized by mixing light emitted from the semiconductor light emitting element and multiple fluorescence emitted by the fluorescent bodies excited by the light emitted from the semiconductor light emitting element. By using such a color mixing method, illumination light specified by various spectra including white light can be emitted, depending on the purpose as described in, e.g., JP-2015-126160 A. For example, illumination light specified by a spectrum similar to the spectrum of sunlight can be realized. In a case in which a violet light component included in illumination light has a high intensity, it is difficult to approximate the spectrum of the illumination light to the spectrum of sunlight. On the other hand, in a case in which the violet light component included in the illumination light has a low intensity, it is difficult to improve color rendering properties of the illumination light. Thus, the intensity of violet light needs to be increased.

The lighting apparatus may emit illumination light for the purpose of achieving an antibacterial effect. If the illumination light includes ultraviolet rays, the ultraviolet rays have the antibacterial effect but can affect the human body. A lighting apparatus that realizes the antibacterial effect while reducing an influence on a user is desired. On the other hand, violet light has an antibacterial effect while being unlikely to have an influence on the human body. Thus, an increase in the intensity of violet light is desired.

According to the light emitting apparatus and the lighting apparatus of an embodiment of the present disclosure, the intensity of violet light in the illumination light can be increased. As a result, the antibacterial effect based on violet light can be realized and, simultaneously, the color rendering properties of the illumination light can be improved.

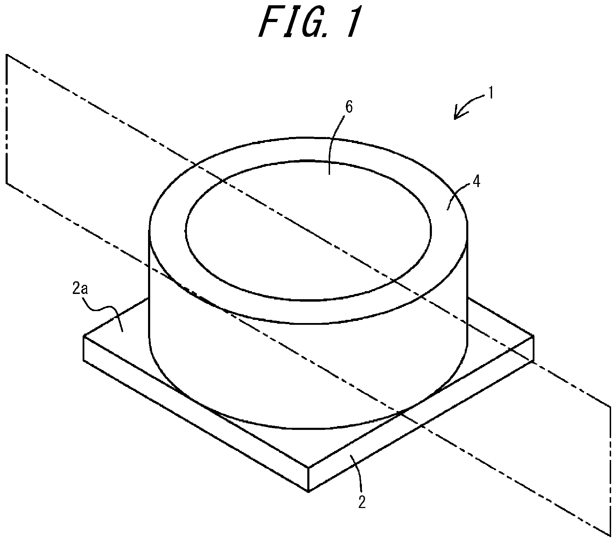

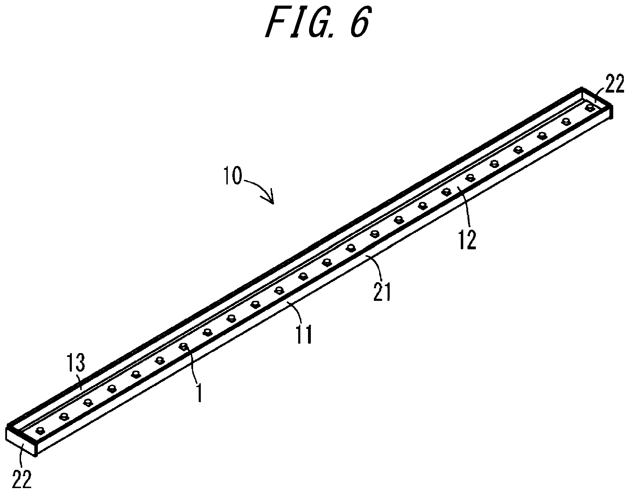

Hereinafter, a light emitting apparatus 1 (see FIG. 1) and a lighting apparatus 10 (see FIG. 6) according to the embodiment of the present disclosure will be described with reference to the drawings.

### Configuration of Light Emitting Apparatus 1

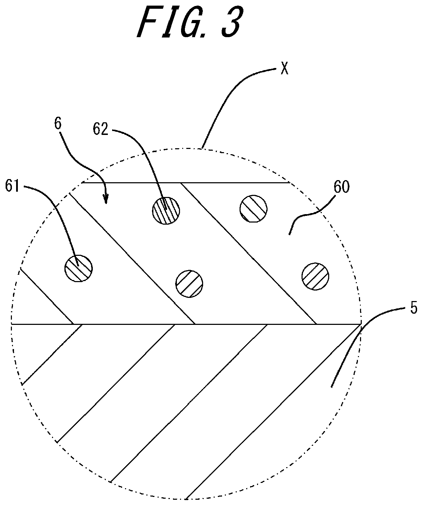

As illustrated in FIG. 1, FIG. 2 and FIG. 3, the light emitting apparatus 1 includes a substrate 2, light emitting elements 3 arranged on the substrate 2, and a frame 4 arranged surrounding the light emitting elements 3 on the substrate 2. The light emitting apparatus 1 further includes a sealing member 5 filled in an inner space surrounded by the frame 4, and a wavelength conversion member 6 arranged on the sealing member 5. The sealing member 5 is filled in the inner space surrounded by the frame 4, except for an upper portion of the inner space. The wavelength conversion member 6 is arranged in the portion of the inner space surrounded by the frame 4 where the sealing member 5 is not filled. The wavelength conversion member 6 is arranged in a manner as to fit in the frame 4 along a top surface of the sealing member 5. The light emitting element 3 may include, for example, an LED. In a case in which the light emitting element 3 includes the LED, the light emitting element 3 emits light toward the outside due to recombination of electrons and holes in a pn junction using a semiconductor.

The substrate 2 is an insulating substrate and may include, for example, a ceramic material such as alumina or mullite, or a glass ceramic material. The substrate 2 may include a composite material formed from a mixture of a plurality of types of materials. The substrate 2 may include a polymer resin in which metal oxide fine particles are dispersed, to enable an adjustment of a coefficient of thermal expansion of the substrate 2.

The substrate 2 has a first surface 2a. The first surface 2a is also referred to as a top surface of the substrate 2. The substrate 2 includes a wiring conductor for electrically conducting the inside and outside of the substrate 2 at least one of on the first surface 2a of the substrate 2 and the inside of the substrate 2. The wiring conductor may include a conductive material such as, for example, tungsten, molybdenum, manganese, or copper. In a case in which the substrate 2 is formed from a ceramic material, the substrate 2 including the wiring conductor may be formed by, for example, laminating and firing a ceramic green sheet on which a metal paste is printed in a predetermined pattern. The metal paste can be obtained by, for example, adding an organic solvent to a powder such as a tungsten powder. The wiring conductor may be treated with, for example, nickel or gold plating to prevent oxidation. A metal reflective layer including, for example, aluminum, silver, gold, copper, platinum, or the like may be formed on the first surface 2a of the substrate 2 at a location spaced apart from the wiring conductor and a plating layer. As a result, the first surface 2a can reflect light emitted by the light emitting element 3 upward with respect to the substrate 2 at a high reflectance.

The light emitting element 3 is mounted on the first surface 2a of the substrate 2. The light emitting element 3 may be electrically connected to the plating layer on the surface of the wiring conductor formed on the first surface 2a of the substrate 2 via, for example, a brazing material or solder. The light emitting element 3 includes a translucent base and an optical semiconductor layer formed on the translucent base. The translucent base may be formed by growing the optical semiconductor layer using a chemical vapor deposition method such as an organic metal vapor phase growth method or a molecular beam epitaxial growth method. The translucent base may be formed from, for example, sapphire, gallium nitride, aluminum nitride, zinc oxide, zinc selenide, silicon carbide, silicon (Si), zirconium dibodium, or the like. A thickness of the translucent base may be, for example, between 50 µm and 1000 µm.

The optical semiconductor layer includes a first semiconductor layer formed on the translucent base, a light emitting layer formed on the first semiconductor layer, and a second semiconductor layer formed on the light emitting layer. The first semiconductor layer, the light emitting layer, and the second semiconductor layer may include, for example, a group III nitride semiconductor, a group III-V semiconductor such as gallium fluorescent or gallium arsenide, or a group III nitride semiconductor such as gallium nitride, aluminum nitride, or indium nitride. A thickness of the first semiconductor layer may be, for example, between 1 µm and 5 µm. A thickness of the light emitting layer may be, for example, between 25 nm and 150 nm. A thickness of the second semiconductor layer may be, for example, between 50 nm and 600 nm. The light emitting element 3 configured as described above can emit light specified by a spectrum having a peak wavelength in, for example, a wavelength range from 360 nm to 430 nm.

The frame 4 is formed from, for example, a ceramic material, a porous material, or a resin material mixed with a powder containing metal oxide. The ceramic material includes aluminum oxide, titanium oxide, zirconium oxide, yttrium oxide, or the like. The metal oxide includes aluminum oxide, titanium oxide, zirconium oxide, yttrium oxide, or the like. The frame 4 is joined to the first surface 2a of the substrate 2 via, for example, a resin, a brazing material, a solder, or the like. The frame 4 is located on the first surface 2a of the substrate 2 in a manner surrounding the light emitting element 3 while being spaced apart therefrom. The frame 4 has an inner wall surface 4a that is inclined in a cross-sectional view. The inner wall surface 4a is formed in a manner expanding more to the outside from the frame 4 as it remotes farther from the first surface 2a of the substrate 2. The inner wall surface 4a functions as a reflecting surface that upwardly reflects light emitted from the light emitting element 3. In a case in which the inner wall surface 4a has a circular shape in a plan view, light emitted by the light emitting element 3 can be uniformly reflected to the outside by the inner wall surface 4a.

The frame 4 may have a metal layer that includes tungsten, molybdenum, manganese, or the like on the inner wall surface 4a, and a plating layer including nickel, gold, or the like that covers the metal layer. The plating layer reflects light emitted by the light emitting element 3. An inclination angle of the inner wall surface 4a is set to, for example, between 55 degrees and 70 degrees with respect to the first surface 2a of the substrate 2.

The inner space surrounded by the first surface 2a of the substrate 2 and the inner wall surface 4a of the frame 4 is filled with the sealing member 5 having optical transparency. The sealing member 5 seals the light emitting element 3 so that the light emitting element 3 is not exposed to the outside, and transmits light emitted by the light emitting element 3 to the outside. The sealing member 5 is filled in the inner space surrounded by the substrate 2 and the frame 4, except for the upper portion of the inner space. The sealing member 5 may include, for example, an insulating resin having light transmitting properties such as a silicone resin, an acrylic resin, or an epoxy resin, or a glass material having light transmitting properties. A refractive index of the sealing member 5 is set to, for example, between 1.4 and 1.6.

The wavelength conversion member 6 is located in the upper portion of the inner space surrounded by the substrate 2 and the frame 4 along the top surface of the sealing member 5. The wavelength conversion member 6 is positioned in a manner as to fit below the top surface of the frame 4. The wavelength conversion member 6 includes a light transmitting member 60 having light transmitting properties and a fluorescent body. The fluorescent body may include, for example, at least one of a first fluorescent body 61 and a second fluorescent body 62. Light emitted by the light emitting element 3 is incident on the wavelength conversion member 6 via the sealing member 5 and excites the fluorescent body. Light emitted by the light emitting element 3 to excite the fluorescent body is also referred to as excitation light. When being excited, the fluorescent body emits light having a wavelength according to its emission characteristics. As a result, at least a portion of light emitted by the light emitting element 3 is converted into light having a different wavelength by the wavelength conversion member 6 and emitted to the outside of the light emitting apparatus 1. In this way, the wavelength conversion member 6 converts the wavelength of light emitted by the light emitting element 3. Light that is not converted by the wavelength conversion member 6, from among light emitted by the light emitting element 3, is emitted to the outside of the light emitting apparatus 1 without conversion. As a result, the light emitting apparatus 1 emits a combination of light converted from excitation light by the wavelength conversion member 6 and light that is emitted without being converted from excitation light by the wavelength conversion member 6. Light emitted by the light emitting apparatus 1 is also referred to as illumination light. The illumination light corresponds to the combination of light converted from the excitation light by the wavelength conversion member 6 and light that is emitted without being converted from the excitation light by the wavelength conversion member 6.

The light transmitting member 60 may be formed from, for example, an insulating resin having light transmitting properties such as a fluororesin, a silicone resin, an acrylic resin, or an epoxy resin, or a glass material having light transmitting properties. The fluorescent body may be included in the light transmitting member 60. The fluorescent body may be uniformly dispersed in the light transmitting member 60.

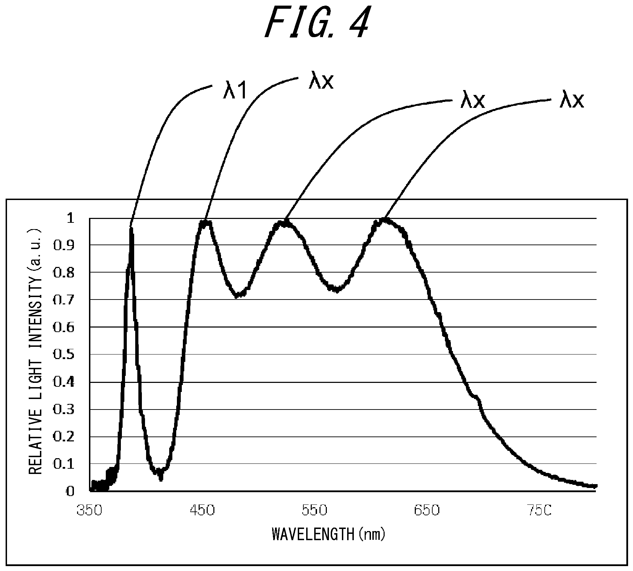

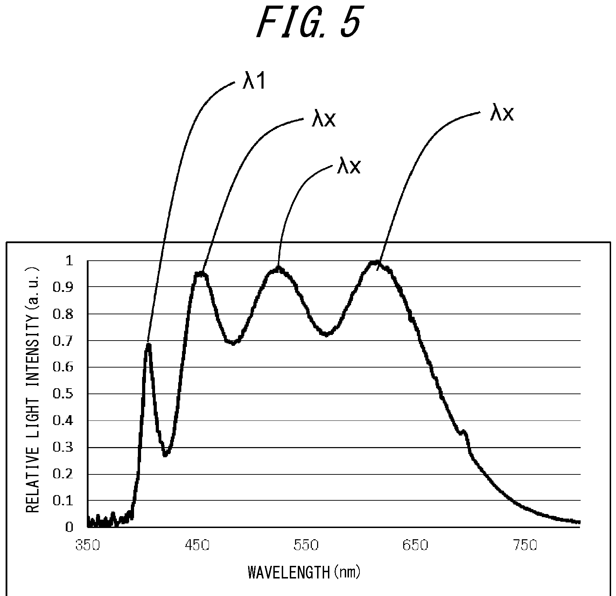

The light emitting apparatus 1 emits light specified by a predetermined spectrum as the illumination light. The spectrum of light can be measured by, for example, performing spectroscopy using a spectrophotometer or the like. The light emitting apparatus 1 may be configured to emit light specified by the light emission spectra illustrated in FIG. 4 and FIG. 5 by way of example. In FIG. 4 and FIG. 5, a horizontal axis represents a wavelength. A vertical axis represents a relative light intensity. The relative light intensity is expressed as a ratio of the light intensity of each wavelength to a light intensity of a peak wavelength. That is, the relative light intensity of light at the peak wavelength is 1. Here, the light intensity corresponds to the magnitude of amplitude. It can also be said that the light intensity corresponds to the number of photons included in light. The light intensity can be measured using, for example, a monochromator. An emission spectrum of the light emitting apparatus 1 may have, for example, a peak wavelength in the wavelength range from 360 nm to 430 nm and a peak wavelength in a wavelength range from 360 nm to 780 nm. Light having a peak wavelength in the wavelength range from 360 nm to 430 nm is also referred to as violet light. The wavelength range from 360 nm to 430 nm is also referred to as a violet light region. Light having a peak wavelength in the wavelength range from 360 nm to 780 nm is also referred to as visible light. The wavelength range from 360 nm to 780 nm is also referred to as a visible light region.

In the present embodiment, the peak wavelength may be represented by a wavelength at which the relative light intensity is maximized, that is, a wavelength corresponding to a peak located between two adjacent roughs in the spectrum. At this time, the spectrum may have small peaks and valleys, such as when a fluorescent body is used to emit light of various colors. Thus, for example, when a wavelength width from a given trough to its adjacent trough is 20 nm or less, a maximum value does not have to be regarded as a peak wavelength. Further, when a difference between the relative light intensity at the trough and the relative light intensity at the peak is a predetermined value or less, a wavelength corresponding to the peak does not need to be regarded as the peak wavelength. The predetermined value may be, for example, 0.001.

Each of the emission spectra in FIG. 4 and FIG. 5 has a first peak wavelength λ1 and a plurality of second peak wavelengths λx. The first peak wavelength λ1 is included in the wavelength range from 360 nm to 430 nm. At least some of the light emitting elements 3 are configured to emit light specified by a spectrum having the first peak wavelength λ1 as excitation light. A material of the fluorescent body may be selected so that light emitted by the light emitting apparatus 1 is specified by the emission spectrum illustrated in FIG. 4. The material of the fluorescent body may be configured to convert excitation light into light specified by the spectrum having at least one of the plurality of second peak wavelengths λx. The second peak wavelength λx is included in the wavelength range from 360 nm to 780 nm. The fluorescent body may be configured to convert the excitation light into light of various colors such as blue, blue-green, green, or red. A wavelength of blue light may be included in a wavelength range from 400 nm to 500 nm. A wavelength of blue-green light may be included in a wavelength range from 450 nm to 550 nm. A wavelength of green light may be included in a wavelength range from 500 nm to 600 nm. A wavelength of red light may be included in a wavelength range from 600 nm to 700 nm. The fluorescent body may be configured to convert excitation light into light having a wavelength in a near-infrared region. The near-infrared region may correspond to a wavelength range from 680 nm to 2500 nm.

The wavelength conversion member 6 may include at least one type of the fluorescent bodies that respectively convert excitation light into blue light, blue-green light, green light, and red light, and a fluorescent body that converts excitation light into light having a wavelength in the near-infrared region. The first fluorescent body 61 and the second fluorescent body 2 may include respective materials that convert excitation light into lights of different colors. The light emitting apparatus 1 may include a plurality of wavelength conversion members 6. In this case, each of the wavelength conversion members 6 may have a combination of different types of fluorescent bodies. The light emitting apparatus 1 may emit light converted by each of the wavelength conversion members 6 and mixed together as illumination light. The light emitting apparatus 1 configured as described above can easily control the color rendering properties of light to be emitted.

The fluorescent body that converts excitation light into blue light may include, for example, BaMgAl₁₀O₁₇:Eu, (Sr,Ca,Ba)₁₀(PO₄)₆Cl₂:Eu, (Sr,Ba)₁₀(PO₄)₆Cl₂:Eu, or the like. The fluorescent body that converts excitation light into blue-green light may include, for example, (Sr,Ba,Ca)₅(PO₄)₃Cl:Eu, Sr₄Al₁₄O₂₅:Eu, or the like. The fluorescent body that converts excitation light into green light may include, for example, SrSi₂(O,Cl)₂N₂:Eu, (SrBa,Mg)₂SiO₄:Eu²⁺, ZnS:Cu,Al, Zn₂SiO₄:Mn, or the like. The fluorescent body that converts excitation light into red light may include, for example, Y₂O₂S:Eu, Y₂O₃:Eu, SrCaClAlSiN₃:Eu²⁺, CaAlSiN₃:Eu, CaAlSi(ON)₃:Eu, or the like. The fluorescent body that converts excitation light into light having a wavelength in the near infrared region may include 3Ga₅O₁₂:Cr or the like.

The light emitting apparatus 1 according to the present embodiment synthesizes light emitted by the light emitting element 3 and light converted by the fluorescent body, in the wavelength range from 360 nm to 780 nm. Thus, light having a plurality of second peak wavelengths λx in addition to light having the first peak wavelength λ1 emitted by the light emitting element 3 are emitted.

When the fluorescent body is excited by excitation light, the temperature of the fluorescent body can change. The change in the temperature of the fluorescent body may change an output of light emitted by the fluorescent body. The output of light includes the peak wavelength of light, light intensity, or the like. In the light emitting apparatus 1 according to the present embodiment, the wavelength conversion member 6 includes a plurality of fluorescent bodies. Because of having a plurality of fluorescent bodies, even if an output of light emitted by one fluorescent body changes, the output of light emitted by the light emitting apparatus 1 as a whole is averaged by light emitted by the other fluorescent bodies. As a result, a variation in the output of light emitted by the light emitting apparatus 1 as a whole can be suppressed.

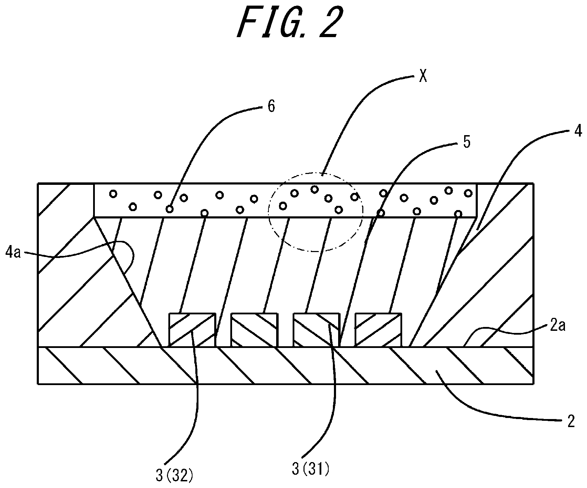

The light emitting apparatus 1 illustrated in FIG. 1 and FIG. 2 was actually manufactured, and its color rendering properties were evaluated. The light emitting element 3 for emitting excitation light was configured using gallium nitride as a material to emit light specified by a spectrum having a plurality of peak wavelengths in the wavelength band between 360 nm and 780 nm. As a fluorescent body that converts excitation light into blue light, (Sr,Ca,Ba)₁₀(PO₄)₆Cl₂:Eu was used. As a fluorescent body that converts excitation light into blue-green light, Sr₄Al₁₄O₂₅:Eu was used. As a fluorescent body that converts excitation light into green light, SrSi₂(O,Cl)₂N₂:Eu was used. As a fluorescent body that converts excitation light into red light, CaAlSi(ON)₃:Eu was used. As a fluorescent body that converts excitation light into light having a wavelength in the near infrared region, 3Ga₅O₁₂:Cr was used. An emission spectrum of the illumination light emitted by the light emitting apparatus 1 configured as described above corresponds to an emission spectrum illustrated in FIG. 4. In the emission spectrum illustrated in FIG. 4, differences in relative light intensities between the plurality of second peak wavelengths λx are small. As a result, it can be said that the emission spectrum illustrated in FIG. 4 is a spectrum that demonstrates high color rendering properties.

The antibacterial effect varies depending on a level of light energy applied to given bacteria. For example, when light has large light energy in the violet light region, the antibacterial effect is exhibited even if light is applied to the given bacteria for a short time. For example, when light has small light energy in the violet light region, the antibacterial effect is exhibited by extending a light irradiation time to irradiate the given bacteria with light. However, when the light energy in the violet light region is too large, the user's skin or the like may be damaged, regardless of the length of the light irradiation time. Further, if the light energy in the violet light region is too small, the given bacteria may grow before the antibacterial effect is exhibited. Thus, light energy to be irradiated to the given bacteria may be appropriately determined in consideration of balancing between the antibacterial effect and a defect caused by the light energy.

In the illumination light emitted by the light emitting apparatus 1 according to the present embodiment, a total energy of light having a wavelength included in the wavelength range from 360 nm to 430 nm may be between 3% and 18% of a total energy of light having a wavelength included in the wavelength range from 360 nm to 780 nm. That is, in the illumination light, the total energy of light in the visible light region may be between 3% and 18% of the total energy of light in the violet light region. Here, the light energy is a sum of energies of photons included in light. The energy of a photon is determined based on a wavelength of the photon. Thus, the light energy is determined based on the relative light intensity of each wavelength of a spectrum that specifies the light. The light energy can be measured using, for example, a photon meter or the like. By specifying the energy of illumination light in this way, the light emitting apparatus 1 can realize the antibacterial effect of violet light while emitting visible light. Because the energy of violet light is 18% or less of the energy of the entire visible light, damage to the skin of the human body due to violet light can be reduced in daily life. Further, because the energy of violet light is 3% or more of the energy of the entire visible light, the antibacterial effect can be increased.

The emission spectrum that specifies the illumination light emitted by the light emitting apparatus 1 according to the present embodiment may have a peak wavelength in a wavelength range from 400 nm to 410 nm. As will be described later, light having a peak wavelength in the wavelength range from 400 nm to 410 nm can exhibit a better antibacterial effect than light having other wavelengths in the violet light region.

In the illumination light emitted by the light emitting apparatus 1 according to the present embodiment, a total energy of the light having a wavelength included in a wavelength range from 430 nm to 500 nm may be between 5% and 30% of the energy of light having a wavelength included in the wavelength range from 360 nm to 780 nm. Light having a wavelength included in the wavelength range from 430 nm to 500 nm can correspond to blue light. By limiting the energy of blue light within a predetermined range, so-called blue light is reduced. As a result, a burden on the eyeball and the like due to blue light included in the illumination light can be reduced, and the color rendering properties of the illumination light can be improved.

In the illumination light emitted by the light emitting apparatus 1 according to the present embodiment, a half width of the spectrum having the peak wavelength in the wavelength range from 360 nm to 430 nm may be between 8 nm and 24 nm. Here, the half width is a width of a wavelength at which the relative light intensity in the spectrum is 50% of the peak intensity. The half width can be calculated based on a measurement result of the spectrum. By determining the half width as described above, energy can be concentrated in a specific wavelength range in the violet light region. As a result, the illumination light can exhibit a high antibacterial effect against a particular type of bacteria.

In the illumination light emitted by the light emitting apparatus 1 according to the present embodiment, a total energy of light having a wavelength included in the wavelength range less than 360 nm may be 2% or less of the total energy of light having a wavelength included in the wavelength range from 360 nm to 780 nm. That is, the energy of ultraviolet rays may be 2% or less of the energy of visible light. In this way, the intensity of ultraviolet rays in the illumination light is reduced. Comparing to a case in which the energy of ultraviolet rays is 2% or more of the energy of visible light, damage to the skin of the human body due to ultraviolet rays can be reduced.

In the illumination light emitted by the light emitting apparatus 1 according to the present embodiment, a half width of the spectrum having a peak wavelength in the wavelength range from 430 nm to 500 nm may be between 25 nm and 60 nm. In this way, the color rendering properties as white light in the illumination light can be improved, and the energy of blue light can be reduced. By reducing the energy of blue light, the burden on the eyeball can be reduced.

In the illumination light emitted by the light emitting apparatus 1 according to the present embodiment, an intensity of light having a wavelength included in the wavelength range from 360 nm to 400 nm may be between 0.003 J/cm² and 18 J/cm² per hour. In this way, the antibacterial effect is exhibited while damage to the skin and the like can be reduced.

In the illumination light emitted by the light emitting apparatus 1 according to the present embodiment, an irradiance of light having a wavelength included in the wavelength range from 360 nm to 400 nm may be less than 10 W • m⁻². The irradiance corresponds to an illuminance of illumination light received by an object such as a living organism illuminated by the illumination light at a distance where the object can approach the light emitting apparatus 1 within a range of a normal life. By specifying the irradiance as described above, the antibacterial effect can be exhibited and, simultaneously, the irradiance can satisfy to belong to an exemption group for near-ultraviolet radiation injury to the eyes defined by JIS (Japanese Industrial Standards). As a result, the light emitting apparatus 1 can maintain functioning as an interior light or the like and simultaneously reduce the risk of causing damage to the eyeball and the like.

In the illumination light emitted by the light emitting apparatus 1 according to the present embodiment, the irradiance of light having a wavelength included in the wavelength range from 360 nm to 430 nm may be 33 W • m⁻² or less. In this way, the antibacterial effect can be exhibited and, simultaneously, the irradiance can satisfy to belong to a low risk group for near-ultraviolet radiation injury to the eyes defined by the JIS. As a result, the light emitting apparatus 1 can maintain functioning as an interior light or the like and simultaneously reduce the risk of causing damage to the eyeball and the like.

In the illumination light emitted by the light emitting apparatus 1 according to the present embodiment, a radiance of light having a wavelength included in the wavelength range from 430 nm to 500 nm may be less than 100 W · sr⁻¹ · m⁻². The radiance corresponds to a brightness of illumination light received by an object such as a living organism illuminated by illumination light at a distance where the object can approach the light emitting apparatus 1 within the range of a normal life. By specifying the radiance in this way, the antibacterial effect can be exhibited and, simultaneously, the radiance can satisfy to belong to an exemption group of retinal injury caused by blue light defined by the JIS. As a result, the light emitting apparatus 1 can reduce the risk of causing damage to the retina and the like.

Fundamentally, the antibacterial effect is determined depending on a level of energy applied to given bacteria. When light has large energy of violet light, light can exhibit a large antibacterial effect even if the light irradiation time is short. Light having energy of violet light smaller than a predetermined value can exhibit the antibacterial effect equivalent to that of light having energy of violet light of more than the predetermined value, by extending the light irradiation time. However, if the energy of violet light is too large, it may accelerate damage to the skin or the like irradiated with the light. If the energy of violet light is too small, the antibacterial effect cannot be sufficiently exhibited, and there is a risk that the bacteria may grow. Because the light emitting apparatus 1 according to the present embodiment is configured in a manner described above, the light emitting apparatus 1 can emit illumination light that is capable of improving the antibacterial effect while using visible light used in daily life.

Further, the light emitting apparatus 1 according to the present embodiment can emit light having high color rendering properties similar to the spectrum of sunlight. That is, a difference between a relative light intensity of each wavelength in the spectrum of the illumination light emitted by the light emitting apparatus 1 according to the present embodiment and a relative light intensity of each wavelength in the spectrum of sunlight can be reduced. As a result, the light emitting apparatus 1 according to the present embodiment can emit illumination light specified by a spectrum similar to the spectrum of sunlight.

The light emitting apparatus 1 may include a plurality of light emitting elements 3. The plurality of light emitting elements 3 may include a first light emitting element 31 and a second light emitting element 32. An intensity of excitation light emitted by the first light emitting element 31 and an intensity of excitation light emitted by the second light emitting element 32 may be controlled separately or in association with each other. The light emitting apparatus 1 may cause the excitation light from the first light emitting element 31 to be incident on a part of the wavelength conversion member 6 and the excitation light from the second light emitting element 32 to be incident on another part of the wavelength conversion member 6. The fluorescent body arranged in the portion of the wavelength conversion member 6 where the excitation light is to be incident from the first light emitting element 31 and the fluorescent body arranged in the portion of the wavelength conversion member 6 where the excitation light is to be incident from the second light emitting element 32 may be of different types. The light emitting apparatus 1 configured in this way can make a spectrum of light converted from excitation light from the first light emitting element 31 and a spectrum of light converted from excitation light from the second light emitting element 32 different from each other. The light emitting apparatus 1 may control the spectrum of synthesized light obtained by converting excitation light emitted by the first light emitting element 31 and excitation light emitted by the second light emitting element 32 using the wavelength conversion member 6, by controlling the intensities of the respective excitation light in association with each other. The light obtained by synthesizing light converted from each of the excitation light emitted by the first light emitting element 31 and the excitation light emitted by the second light emitting element 32 using the wavelength conversion member 6 is also referred to as synthetic light. The light emitting apparatus 1 may emit the synthetic light as illumination light. The light emitting apparatus 1 may emit excitation light by selecting at least one of the first light emitting element 31 and the second light emitting element 32.

The light emitting apparatus 1 according to the present embodiment may be used in a state in which, for example, a plurality of light emitting apparatuses 1 are arranged to illuminate the inside of a building or a house. For example, the light emitting apparatus 1 can create an illumination environment in which as if sunlight is irradiated indoors, by illuminating a living space. Further, the light emitting apparatus 1 can create an inspection environment in which as if sunlight is irradiated indoors by illuminating an inspection target, to inspect the appearance of a painted object such as, for example, a passenger car. Light similar to sunlight irradiated indoors can make the appearance similar to that in color observed under sunlight. That is, the color rendering properties are improved. By improving the color rendering properties, an accuracy of color inspection can be improved. Further, for an activity in an indoor living environment or breeding of a living organism to be bred indoors, the light emitting apparatus 1 can illuminate the environment such as a breeding space or the like while exhibiting the antibacterial effect. That is, the light emitting apparatus 1 may be used as an antibacterial light. As a result, the light emitting apparatus 1 becomes useful to maintain a health state of the living organism. Thus, the light emitting apparatus 1 according to the present embodiment is effectively used to illuminate in a facility such as a hospital or a hot spring facility that requires the antibacterial effect, an animal breeding facility including a pet shop, an indoor space such as a kitchen, a washroom, a bathroom, and the like where bacteria can easily propagate. Further, the light emitting apparatus 1 is also effectively used in a place such as a refrigerator or a showcase in a sushi restaurant where it is desired to make food look delicious while suppressing the growth of bacteria for hygienic reasons.

### Configuration of Lighting Apparatus 10

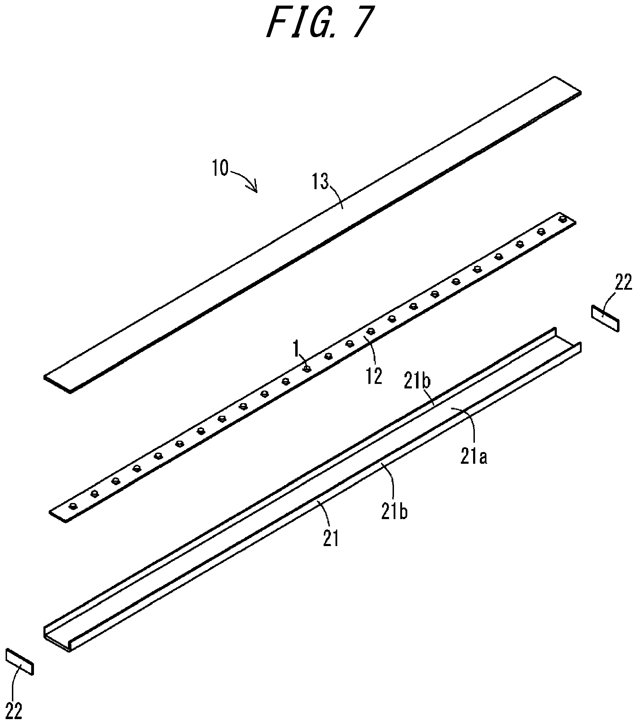

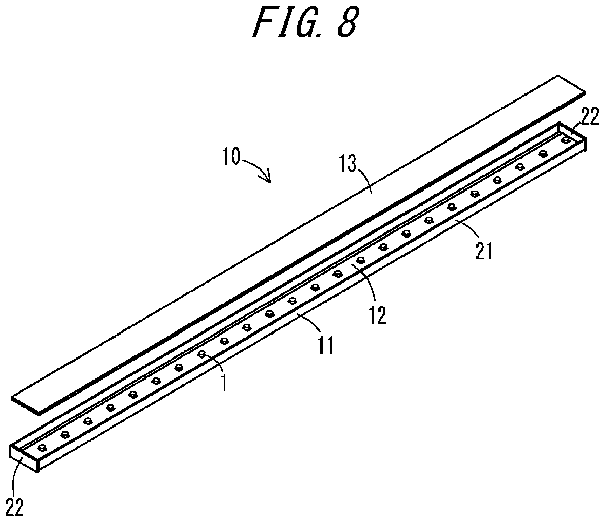

Although the embodiment of the light emitting apparatus 1 has been described, the light emitting apparatus 1 may be included in a part of the lighting apparatus 10 as illustrated in FIG. 6, FIG. 7, and FIG. 8

The lighting apparatus 10 includes a plurality of light emitting apparatuses 1 each including light emitting elements 3. The lighting apparatus 10 emits light formed by a combination of light emitted by each of the plurality of the light emitting apparatuses 1 as illumination light. The illumination light emitted by the lighting apparatus 10 may be specified by various spectra described above as the spectrum of light emitted by one light emitting apparatus 1. The lighting apparatus 10 including the plurality of light emitting apparatuses 1 may emit illumination light specified by a spectrum having the first peak wavelength λ1 in the wavelength range from 360 nm to 430 nm and a plurality of second peak wavelengths λx in the wavelength range from 360 nm to 780 nm. When the spectrum of the illumination light emitted by the lighting apparatus 10 has the first peak wavelength λ1 in the wavelength range from 360 nm to 430 nm, the spectrum of illumination light can be similar to the spectrum of sunlight.

The spectra illustrated in FIG. 4 and FIG. 5 by way of example represent examples of the spectrum of illumination light emitted by the light emitting apparatus 1. The spectrum of the illumination light emitted by the lighting apparatus 10 as a whole may be the spectrum illustrated in FIG. 4 and FIG. 5 by way of example.

The lighting apparatus 10 includes a housing 11 having a long length, a plurality of light emitting apparatuses 1, a circuit board 12 having a long length, and a light transmitting board 13. The housing 11 is open upward. The plurality of light emitting apparatuses 1 are arranged in a line in the housing 11 along a longitudinal direction and mounted on the circuit board 12. The translucent substrate 13 is supported by the housing 11 and closes the opening of the housing 11.

The housing 11 supports the translucent substrate 13. The housing 11 can dissipate heat generated from the light emitting apparatus 1 to the outside. The housing 11 is formed including, for example, a metal such as aluminum, copper or stainless steel, a plastic, or a resin. The housing 11 has a longitudinal direction and a transverse direction. The housing 11 includes a body 21 and two covers 22 located at both ends in the longitudinal direction. The body 21 includes a bottom portion 21a having a longitudinal direction and a transverse direction, and a pair of support portions 21b. The pair of support portions 21b is erected from each of a pair of sides located at both ends of the bottom portion 21a in the transverse direction and extends in the longitudinal direction. The body 21 has a U-shape in a cross-sectional view intersecting with the longitudinal direction. The body 21 has openings at both ends of the longitudinal direction. The covers 22 are located covering the openings at both ends of the longitudinal direction of the body 21. In an upper portion of each of the support portions 21b on an inner side of the housing 11, a support portion in which recesses for supporting the translucent substrate 13 face each other along the longitudinal direction is formed. A length of the housing 11 in the longitudinal direction is set to, for example, between 100 mm and 2000 mm.

The circuit board 12 is fixed to a bottom surface (the bottom portion 21a) inside the housing 11. The circuit board 12 is, for example, a printed circuit board such as a rigid board, a flexible board, or a rigid flexible board. A wiring pattern of the circuit board 12 and a wiring pattern of the substrate 2 of the light emitting apparatus 1 are electrically connected to each other via a solder or a conductive adhesive. Then, a signal from the circuit board 12 is transmitted to the light emitting element 3 via the substrate 2, whereby the light emitting element 3 emits light. Electric power is supplied to the circuit board 12 from an external power source via wiring. The power source may include, for example, a button battery or the like, or may include various other power sources. The circuit board 12 may be equipped with a controller configured to output a control signal for controlling the light emitting element 3. The controller may be, for example, a processor or the like.

The translucent substrate 13 is formed from a material that transmits light emitted by the light emitting apparatus 1. The translucent substrate 13 is formed from a material having optical transparency such as, for example, an acrylic resin, a glass, or the like. The translucent substrate 13 may be a rectangular plate. A longitudinal length of the translucent substrate 13 is set to, for example, between 98 mm and 1998 mm. The translucent substrate 13 is inserted into the recess formed in each of the support portions 21b described above through the opening located on one side of the body 21 in the longitudinal direction and slid along the longitudinal direction. As a result, the translucent substrate 13 is supported by the pair of support portions 21b at a location spaced apart from the plurality of light emitting apparatuses 1. The lighting apparatus 10 is configured by closing the openings located at both ends of the body 21 in the longitudinal direction with the cover 22.

In the lighting apparatus 10 illustrated by way of example in FIG. 6, FIG. 7, and FIG. 8, the plurality of light emitting apparatuses 1 are arranged in a straight line. In this case, the lighting apparatus 10 functions as a line emission light. The plurality of light emitting apparatuses 1 may be arranged in a matrix or a houndstooth pattern, rather than being arranged in the straight line. In this case, the lighting apparatus 10 functions as a surface emission light.

The lighting apparatus 10 according to the present embodiment may be used to illuminate the inside of a building, a house, or the like, or may be used to illuminate an inspection target for visual inspection, in a manner similar to the light emitting apparatus 1. Further, the lighting apparatus 10 may be used as an antibacterial light, in a manner similar to the light emitting apparatus 1.

### Antibacterial Effect

When the emission spectrum of the light emitting apparatus 1 or the lighting apparatus 10 is approximated to the spectrum of sunlight, a user in an environment in which the light emitting apparatus 1 or the lighting apparatus 10 irradiates illumination light can feel comfortable in daily life. Further, an influence on the eyes and skin of the human body can be reduced, and the antibacterial effect against various fungi or molds can be exhibited.

The bacterium against which the violet light exhibits the antibacterial effect described above may include, for example, Escherichia coli, Staphylococcus aureus, drug-resistant Staphylococcus aureus, Salmonella, Shigella, Legionella, Bacillus cereus, or the like. A virus against which violet light exhibits the antibacterial effect may include norovirus or the like. Molds against which violet light exhibits the antibacterial effect may include red mold, black aspergillus, Rhizopus, or the like.

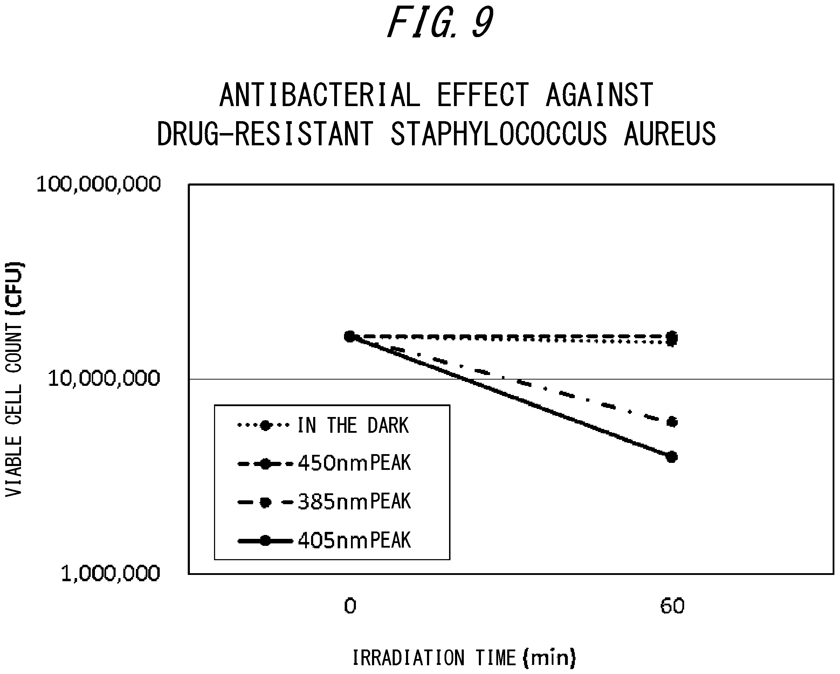

As illustrated in FIG. 9, the antibacterial effect exhibited in a case in which drug-resistant Staphylococcus aureus was irradiated with illumination light emitted by the light emitting apparatus 1 according to the present embodiment was verified. In a graph illustrated in FIG. 9, a horizontal axis represents an irradiation time (unit: minute) of the illumination light. A vertical axis represents a viable cell count (unit: CFU (Colony Forming Unit)). In this verification, the illumination light was controlled so that an irradiance of light in the violet light region was approximately 10 W • m⁻² and irradiated for 60 minutes. When illumination light having a peak wavelength at 385 nm or 405 nm was used, a decrease in the viable cell count was observed. On the other hand, when it is dark and when illumination light having a peak wavelength at 450 nm was used, the viable cell count hardly changed. That is, it can be seen that the antibacterial effect caused by the irradiation of illumination light is exhibited when illumination light has the peak wavelength at 385 nm or 405 nm. This result proves that the antibacterial effect is exhibited by illumination light that includes light in the violet light region, even if illumination light hardly includes an ultraviolet component having a wavelength at less than 360 nm.

On the other hand, the effect of illumination light emitted by the light emitting apparatus 1 according to the present embodiment exhibited to human or animal living cells was verified by carrying out a test with reference to a phototoxicity test conforming to an OECD432 guideline. In the guideline, culture of cells, administration of a test substance, irradiation of light, culture for recovery after the irradiation of light, staining, and measurement of the number of living cells based on the number of stained cells are sequentially performed. In this verification, a step of administrating a test substance was omitted, for the purpose of verifying the effect of light on the cells alone regardless of the presence or absence of the test substance.

Parameters used in the test were set as follows:
Cell type: BALB/3T3 A31
Number of seeds: 1 × 10⁴ per well
(Note: The well corresponds to one section of a cell culture plate.)
Culture time: 24 hours
Buffer: PBS (Phosphate Buffered Saline)
(Note: The buffer refers to a solution added in place of a culture medium during irradiation of light.)
Light irradiation time: 50 minutes
Illuminance: 100,000 lux
(equivalent to 33 mW/cm² when converted into a solar simulator spectrum)
Culture time for recovery: 18 hours
Measurement of living cells: CCK-8 (Cell Counting Kit-8).

The spectra of light irradiated to the cells were defined by the following (1) to (8):
(1) In the dark (A light intensity of each wavelength was 0.)
(2) Ultraviolet rays having a peak wavelength at 254 nm
(3) Light similar to sunlight emitted by a solar simulator
(4) White LED having a peak wavelength of excitation light at 405 nm (violet)
(5) White LED having a peak wavelength of excitation light at 405 nm (violet)
(6) White LED having a peak wavelength of excitation light at 405 nm (violet)
(7) White LED having a peak wavelength of excitation light at 415 nm (violet)
(8) White LED having a peak wavelength of excitation light at 450 nm (blue).

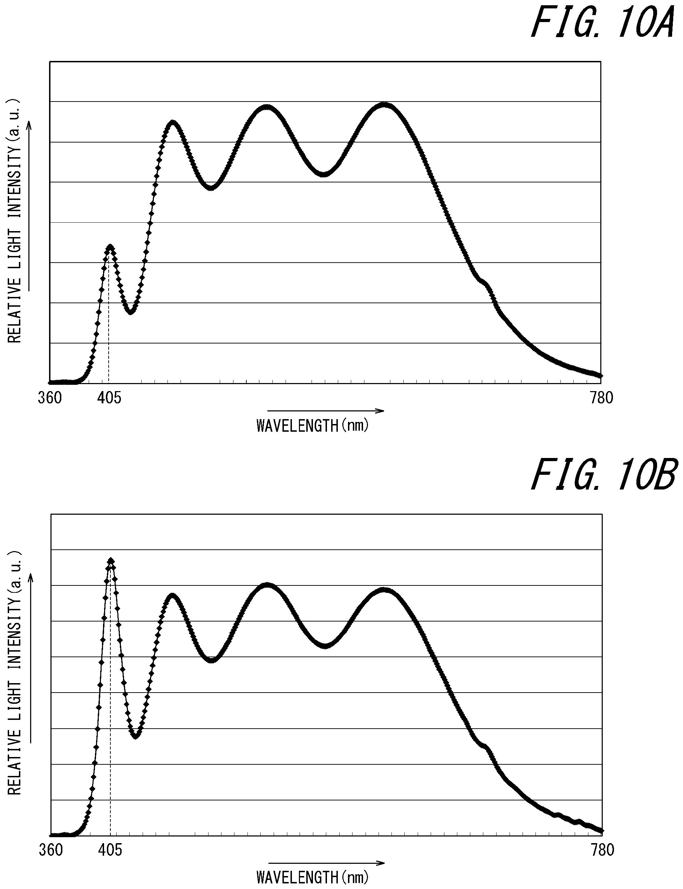

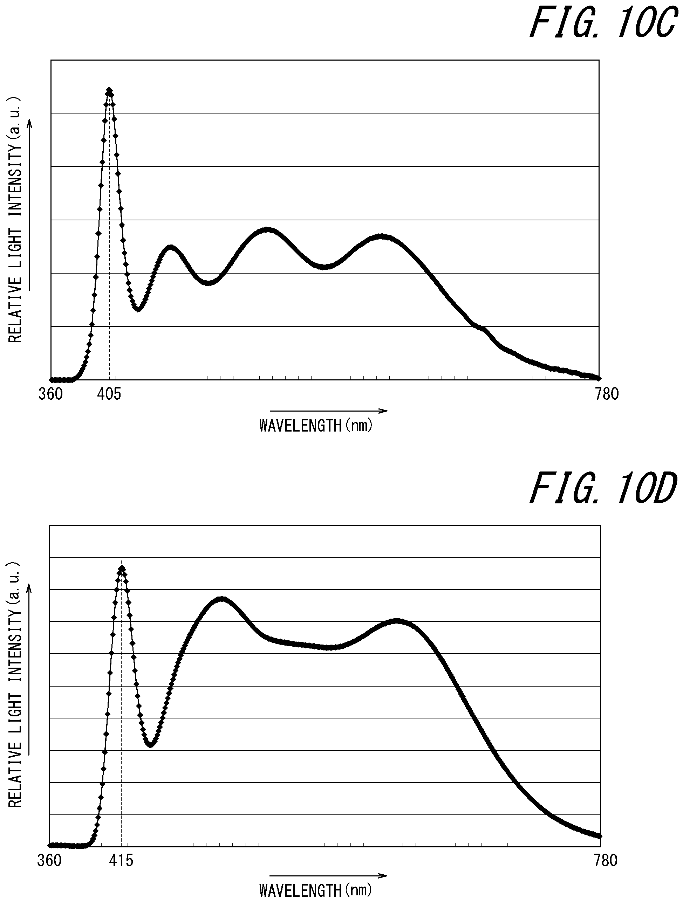

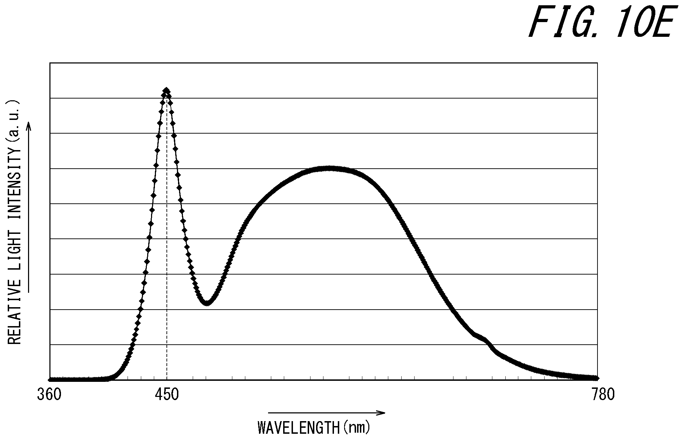

The spectra illustrated in FIG. 10A, FIG. 10B, FIG. 10C, FIG. 10D, and FIG. 10E respectively correspond to the spectra of (4), (5), (6), (7), and (8). In each of graphs illustrated in FIG. 10A to FIG. 10E, a horizontal axis and a vertical axis respectively represent a wavelength and a relative light intensity. The spectra of (4), (5) and (6) are distinguished by the relative light intensity of 405 nm. In the spectrum of (4), the relative light intensity at 405 nm is standard. In the spectrum of (5), the relative light intensity at 405 nm is moderately enhanced. In the spectrum of (6), the relative light intensity at 405 nm is enhanced to a maximum output according to a specification of the apparatus.

In the test described above, the cells were irradiated with light specified by the spectra of (1) to (8) for 50 minutes. As a result, when ultraviolet rays having the spectrum of (2) was irradiated, a cell viability was 2% of a cell viability with respect to the spectrum of (1) set to 100%. Further, cell viabilities with respect to the spectra of (4) to (8) were as follows:
(4) 88%, (5) 104%, (6) 90%, (7) 107%, and (8) 91%.

In the phototoxicity test according to the guideline, it is defined that a test substance is not toxic when the cell viability is 80% or more. Based on this, it was determined that light specified by the spectra of (4) to (8) in our test did not affect the cell viability.

Illumination light needs to be free of harm on a living body while exhibiting the antibacterial effect. As such, when methicillin-resistant Staphylococcus aureus (MRSA: Methicillin Resistant Staphylococcus Aureus) was irradiated with light specified by the spectra of (1) to (8), a change in the viable cell count of MRSA was verified. It can be said that the more the viable cell count is reduced, the higher the antibacterial effect is exhibited against MRSA.

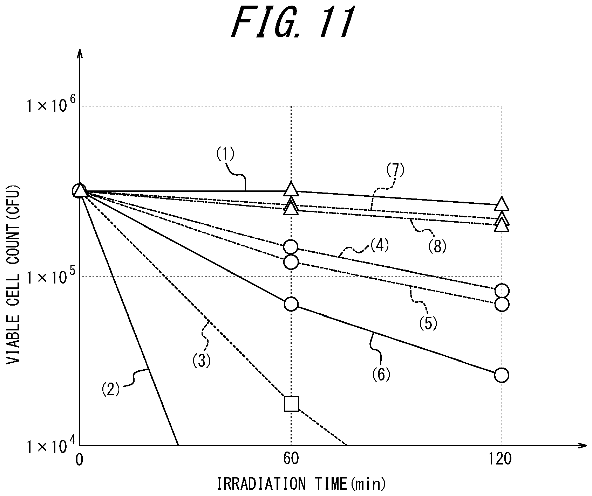

FIG. 11 illustrates changes in the viable cell count when MRSA is irradiated with light specified by each of the spectra of (1) to (8) for 60 minutes and 120 minutes. In the graph illustrated in FIG. 11, a horizontal axis represents a light irradiation time. A vertical axis represents the viable cell count. Data of the spectrum of (1) is plotted as a white triangle, and a change in the viable cell count is represented by a solid line. Data of the spectrum of (2) does not have a plot due to a dramatic decrease in the viable cell count, and a change in the viable cell count is represented by a solid line. Data of the spectrum of (3) is plotted as a white square, and a change in the viable cell count is represented by a broken line. Data of the spectrum of (4) is plotted as a white circle, and a change in the viable cell count is represented by a dashed line. Data of the spectrum of (5) is plotted as a white circle, and a change in the viable cell count is represented by a broken line. Data of the spectrum of (6) is plotted as a white circle, and a change in the viable cell count is represented by a solid line. Data of the spectrum of (7) is plotted as a white triangle, and a change in viable cell count is represented by a broken line. Data of the spectrum of (8) is plotted as a white triangle, and a change in the viable cell count is represented by a dashed line.

When ultraviolet rays having the spectrum of (2) and light having the spectrum of (3) that includes a high level of ultraviolet rays were irradiated, the viable cell counts were significantly reduced. That is, each of light specified by the spectra of (2) and (3) exhibits a high antibacterial effect against MRSA.

As to the spectrum of (1), i.e., when light was not irradiated, the viable cell count hardly decreased. That is, the spectrum of (1) corresponding to no irradiation light does not exhibit the antibacterial effect against MRSA.

The decreases in the viable cell counts with respect to the spectrum of (7) having the peak wavelength at 415 nm and the spectrum of (8) having the peak wavelength at 450 nm are larger than a decrease with respect to the spectrum of (1) in which MRSA was left standing in the dark. That is, light specified by the spectra of (7) and (8) exhibited the antibacterial effect against MRSA to some extent. It was confirmed that the decreases in the viable cell counts with respect to the spectra of (4), (5) and (6) having the peak wavelength at 405 nm were larger than the decreases in the viable cell counts with respect to the spectra of (7) and (8). It was also confirmed that the viable cell count decreased more as the relative light intensity at 405 nm was increased more. That is, light specified by the spectra of (4), (5) and (6) exhibits a higher antibacterial effect against MRSA than light specified by the spectra of (7) and (8).

In view of the above results, light specified by the spectrum having the peak wavelength at 405 nm is determined to not have an influence on the cell viability and to exhibit the antibacterial effect on MRSA. Further, light specified by the spectrum having the peak wavelength at 405 nm exhibits a higher antibacterial effect on MRSA than light specified by the spectrum having the peak wavelength at 415 nm. Hence, the emission spectrum that specifies the illumination light emitted by the light emitting apparatus 1 according to the present embodiment may have a peak wavelength in a wavelength range from 400 nm to 410 nm. In this way, the illumination light can exhibit a higher antibacterial effect than light having other wavelengths in the violet light region.

Although in the above test the antibacterial effect of white light including light excited by violet light was verified, it has been confirmed that the antibacterial effect is exhibited also when violet light alone is irradiated. Thus, the light emitting apparatus 1 and the lighting apparatus 10 that include the light emitting element 3 configured to emit violet light can exhibit the antibacterial effect.

It can be said that the test described above verifies an antibacterial action of visible light against bacteria, i.e., a so-called visible light antimicrobial activity (VLA: Visible light antimicrobial activity).

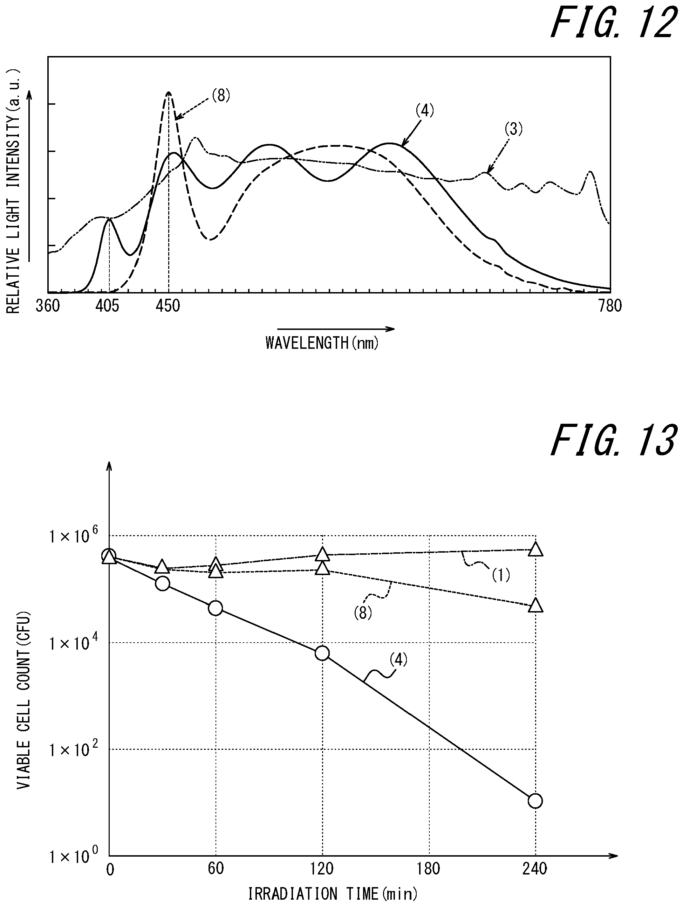

As another example test different from the test described above, a test for the purpose of comparing violet light with sunlight or blue light was conducted. In the another example test, effects on cells were verified in cases in which the cells were irradiated with light specified by the spectra of (1), (3), (4) and (8), from among the spectra of (1) to (8) used in the test described above. The spectra of (3), (4) and (8) used in the another example test are illustrated in FIG. 12, by way of example.

The another example test includes an antibacterial test and a cell viability confirmation test. In the antibacterial test, an amount of light specified by each of the spectra of (3), (4) and (8) excluding the spectrum of (1) corresponding to "in the dark' was set to 100,000 lux, which is equivalent to an amount of light of a surgical light. A light irradiation time was set to 4 hours. A subject to be irradiated with light was obtained by preparing MRSA of approximately 10⁵ CFU in a general broth medium of 20 µL diluted to a concentration of 1/500 with reference to JIS R1702, which was then placed between two glass plates and brought into close contact with them.

When the MRSA was irradiated with light, the viable cell count of MRSA changed as illustrated in a graph of FIG. 13. In the graph of FIG. 13, a horizontal axis represents the irradiation time (unit: minute). A vertical axis represents the viable cell count (unit: CFU). An amount of decrease in the viable cell count of MRSA when light specified by the spectrum of (8) having the peak wavelength of 450 nm was irradiated is larger than that with respect to the spectrum of (1) in which MRSA was left standing in the dark. That is, light specified by the spectrum of (8) exhibits the antibacterial effect on MRSA to some extent. It was confirmed that an amount of decrease in the viable cell count of MRSA when light specified by the spectrum of (4) having the peak wavelength at 405 nm was irradiated is larger than that of the case in which light specified by the spectrum of (8) was irradiated. That is, light specified by the spectrum of (4) exhibits a higher antibacterial effect on MRSA than light specified by the spectrum of (8).

In the cell viability confirmation test, the amount of light specified by each of the spectra of (3), (4) and (8) excluding the spectrum of (1) corresponding to "in the dark" was set to 100,000 lux, which is equivalent to the amount of light of a surgical light. The light irradiation time was set to 1 hour. A subject to be irradiated with the light was a rabbit corneal cell line (SIRC), with reference to OECD491.

The cell viability of SIRC after irradiation of light specified by the spectrum of (3) similar to sunlight for 1 hour was reduced to 1/10 or less of that of a case in which the rabbit corneal cell line was left standing in the dark. On the other hand, the cell viability of SIRC after irradiation of light specified by the spectrum of (4) for 1 hour did not decrease as compared with the case in which the rabbit corneal cell line was left standing in the dark. That is, light specified by the spectrum of (4) did not affect the corneal cells.

According to the another example test, it was clarified that light specified by the spectrum of (4) exhibits the antibacterial effect without an influence on the corneal cells. Thus, the light emitting apparatus 1 or the lighting apparatus 10 according to the present embodiment can exhibit the antibacterial effect by emitting light having the peak wavelength at 405 nm while being unlikely to have an influence on living cells.

### Embodiments as Gripping Unit

Because the light emitting apparatus 1 and the lighting apparatus 10 according to the present embodiment can exhibit the antibacterial effect while suppressing an influence on the user, they can be used in a place where a human body can be irradiated with light. The light emitting apparatus 1 and the lighting apparatus 10 can be used to irradiate light having the antibacterial effect to, for example, a gripping unit to be gripped by a user.

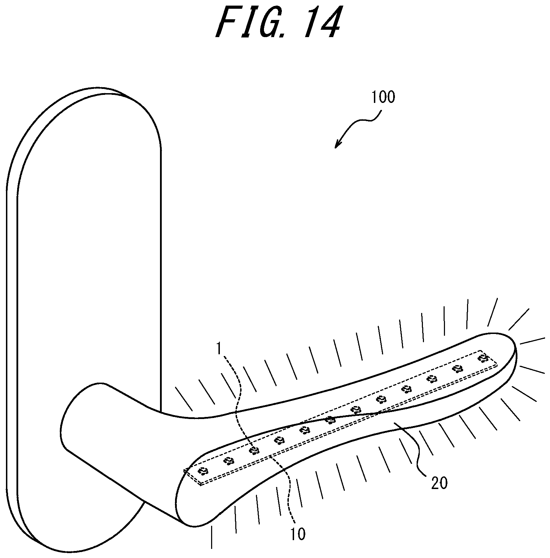

As illustrated in FIG. 14, a gripping unit 100 according to an embodiment includes the light emitting apparatus 1 and a gripping portion 20. The gripping unit 100 may include the light emitting apparatus 10 that includes the light emitting apparatus 1.

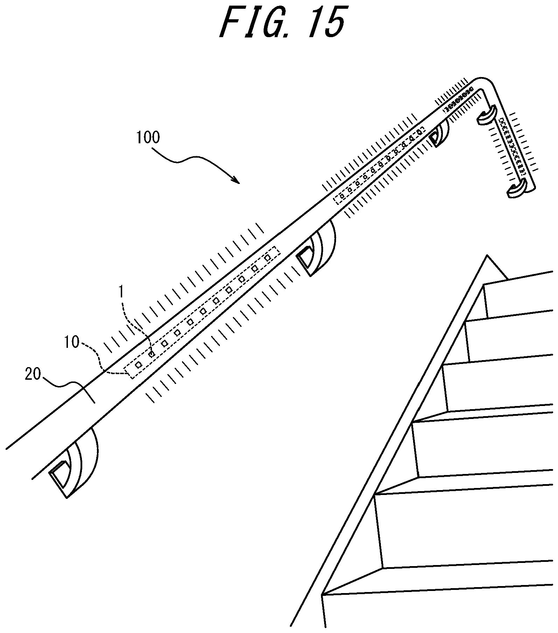

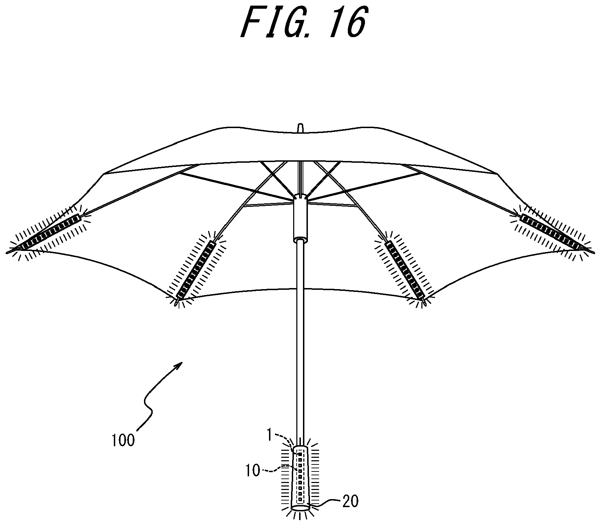

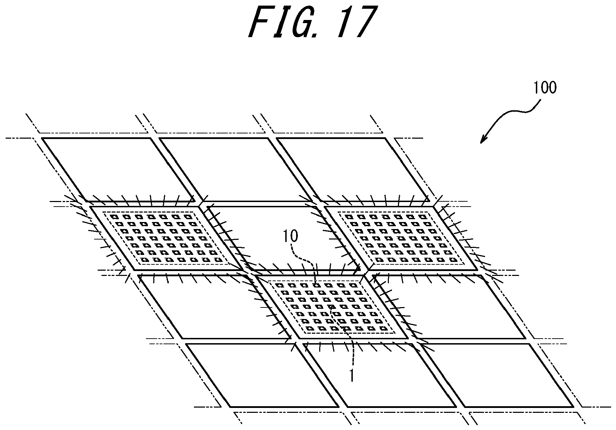

The gripping portion 20 is a member that can be gripped by the user. Here, the member that can be gripped is assumed to include a member at least the user can touch. The member that the user can touch is also referred to as a contact portion. The gripping unit 100 provided with the contact portion is also referred to as a contact object. The gripping portion 20 may include, for example, a handrail or an umbrella to be contacted by the user's hand (see FIG. 15 or FIG. 16). The gripping portion 20 may include, for example, a floor or the like to be contacted by the user's feet (see FIG. 17).

The gripping portion 20 may be configured as, for example, a doorknob. The gripping portion 20 may be configured as, for example, a handle of a sliding door. The gripping portion 20 may be configured as, for example, a handlebar of a bicycle or motorcycle. The gripping portion 20 may be configured as, for example, a handlebar of an exercise bike of a fitness gym. The gripping portion 20 may be configured as, for example, a gripping portion of muscle training equipment. The gripping portion 20 may be configured as, for example, a handrail on a staircase or slope. The gripping portion 20 may be configured as, for example, a lighting keyboard of an electronic organ or electronic piano. The gripping portion 20 may be configured as, for example, a hand strap used in public transportation such as, for example, a bus or the like. The gripping portion 20 may be configured as, for example, a button of an elevator or the like. The gripping portion 20 may be configured as, for example, a handrail of an escalator. The gripping portion 20 may be configured as, for example, an arm rest of a seat in a movie theater or the like. The gripping portion 20 may be configured as, for example, a desk. The gripping portion 20 may be configured as, for example, a faucet handle or a drain in the kitchen. The gripping portion 20 may be configured as, for example, a handle or a drain for shower. The gripping portion 20 may be configured as, for example, an operation button or a touch panel of a mobile device including a smartphone. The gripping portion 20 may be configured as a casing for the mobile device including the smartphone. The gripping portion 20 may be configured as a liquid crystal light of a portable device. The gripping portion 20 may be configured as, for example, an input device such as a keyboard, a mouse, or the like. The gripping portion 20 may be configured as, for example, a backlight of a keyboard. The gripping portion 20 may be configured as, for example, a handle of a pachinko machine or a push button of a slot machine. The gripping portion 20 may be configured as, for example, a handle of an umbrella. The gripping portion 20 may be configured as, for example, a floor of a hot spring facility or the like. The gripping portion 20 may be configured as, for example, a controller of a game machine or an operation button of the controller. The gripping portion 20 may be configured as, for example, a remote controller for operating a device or an operation button of the remote controller. The gripping portion 20 may be configured as, for example, a switch of a power strip. The gripping portion 20 may be configured as, for example, an operation button of various devices. The gripping portion 20 may be configured as, for example, a hand-held shining sphere. The gripping portion 20 may be configured as, for example, a hand-held glowing toy. The gripping portion 20 may be configured as, for example, a kitchen utensil including, for example, a kitchen knife or a peeler. The gripping portion 20 may be configured as, for example, a toilet lever or button. The gripping portion 20 may be configured as, for example, a ballpoint pen.

In an example illustrated in FIG. 14, a doorknob is adopted as the gripping portion 20. In this case, the gripping unit 100 is configured by inserting the lighting apparatus 10 that includes the light emitting apparatus 1 from one side or the other side in a longitudinal direction of the doorknob to be enclosed therein. As a result, the gripping unit 100 having the light emitting apparatus 1 or the lighting apparatus 10 incorporated therein can realize the antibacterial effect while suppressing an influence on the user. That is, the gripping unit 100 can be used as a light that has the antibacterial effect and is very safe.

The gripping portion 20 is formed from, at least in part, a material that transmits light emitted by the light emitting apparatus 1 or the lighting apparatus 10 at a predetermined transmittance. Because the gripping portion 20 is formed from a light-transmitting material, a portion of the gripping portion 20 to be contacted by the user is irradiated with light in the violet light region, which is a part of the visible light region. Thus, the gripping unit 100 can realize the antibacterial effect while suppressing an influence on the user. Further, because the gripping portion 20 is formed from a light-transmitting material, light emitted by the light emitting apparatus 1 or the lighting apparatus 10 can easily be transmitted through the gripping portion 20 in a case in which the light emitting apparatus 1 or the light emitting apparatus 10 is enclosed in the gripping portion 20. As a result, the gripping unit 100 can improve its functionality as a light.

The lighting apparatus 10 is not limited to have a particular shape and may have a shape that conforms to a shape of the gripping portion 20. For example, in a case in which the gripping portion 20 has a tubular shape, the light emitting apparatus 10 may have a rectangular shape (see FIG. 14). For example, in a case in which the gripping portion 20 has a square shape, the light emitting apparatus 10 may have a square shape (see FIG. 15). The lighting apparatus 10 may have various other shapes including a circular shape, an elliptical shape, a rectangular shape, or the like.

A plurality of light emitting apparatuses 1 may be mounted on the lighting apparatus 10. The plurality of light emitting apparatuses 1 are mounted on the lighting apparatus 10 in any arrangement including a matrix pattern, a houndstooth shape, a circular shape, an elliptical shape, or a rectangular shape.

The gripping unit 100 according to the present embodiment includes the light emitting apparatus 1 or the light emitting apparatus 10 configured to emit light in the violet light region, and the gripping portion 20. As described above, light in the violet light region has the antibacterial effect and hardly have an influence on the human body. Thus, the gripping unit 100 that includes the light emitting apparatus 10 configured to emit light in the violet light region can realize the antibacterial effect while suppressing an influence on the user. That is, the gripping unit 100 that has an antibacterial effect and is very safe can be realized. Further, the gripping unit 100 can sanitize the gripping portion 20.

As described above, the light emitting apparatus 1 or the lighting apparatus 10 includes the wavelength conversion member 6 and thus can emit light having various spectra including the emission spectrum similar to that of sunlight. That is, the light emitting apparatus 1 can emit light having high color rendering properties. In a case in which the light emitting apparatus 1 includes the wavelength conversion member 6, the gripping unit 100 has the antibacterial function in addition to the function as a light that is very safe and has high color rendering properties. As a result, the usefulness of the gripping unit 100 is improved.

### Other Examples of Griping Unit

Other examples of the gripping unit 100 according to the present embodiment will be described with reference to FIG. 15, FIG. 16, and FIG. 17. As illustrated in FIG. 15, the gripping unit 100 may be configured as, for example, a handrail that can be gripped by the user. In this case, the gripping portion 20 may correspond to the handrail itself. The light emitting apparatus 1 or the lighting apparatus 10 may be enclosed in the gripping portion 20. The light emitting apparatus 1 or the lighting apparatus 10 may be located external to the gripping portion 20 and may irradiate the gripping portion 20 with light including violet light from the outside.

For example, the handrail may be installed on a wall surface in a staircase or a passage in an elderly nursing home or a hospital. Bacteria or the like are likely to attach to or multiply on a handrail that can be gripped by numerous people.

The handrail configured by the gripping unit 100 has the antibacterial effect by emitting light having a peak wavelength in the violet light region. The handrail having the antibacterial function can reduce bacteria or the like on its surface, even when the handrail is gripped by numerous people. As a result, the handrail can be kept clean. Also, because the handrail has the antibacterial effect, bacteria is suppressed from being passed onto users. Further, when a part of the user's body contacts the handrail having the antibacterial effect, exhibition of the antibacterial effect against bacteria attached to the user can be expected. As a result, user's health can be maintained and illness precaution can be realized.

The handrail configured by the gripping unit 100 may emit light having a peak wavelength in the visible light region. In this case, the handrail can function as a light and can be used as a highly stylish interior in an elderly nursing home, a hospital, or the like. By functioning as a light, the handrail can be easily visible to users in a dark room in the elderly nursing home or the hospital. The handrail may emit light that has high color rendering properties and is in color that makes users feel comfortable in daily life. In this case, the handrail can enhance a relaxing effect on users who spend time in the elderly nursing home or the hospital.

An installation location of the handrail is not limited to the above examples. The handrail configured by the gripping unit 100 can be installed at various locations.

As illustrated in FIG. 16, the gripping unit 100 may be configured as, for example, an umbrella that the user can hold. The umbrella may include, for example, a portable parasol or an umbrella that enables the user to walk while holding it. In this case, the gripping portion 20 may correspond to a handle of the umbrella. The handle of the umbrella is also referred to as a handle or a hand. The light emitting apparatus 1 or the lighting apparatus 10 may be enclosed in the gripping portion 20. The light emitting apparatus 1 or the lighting apparatus 10 may be located external to the gripping portion 20 to irradiate the gripping portion 20 with light including violet light from the outside.

The umbrella configured by the gripping unit 100 exhibits the antibacterial effect by emitting light having a peak wavelength in the violet light region. Thus, bacteria or the like are suppressed from growing on the handle of the umbrella, even when the user repeatedly grips the handle of the umbrella. As a result, the umbrella can be kept clean. Further, exhibition of the antibacterial effect against bacteria attached to the user's hand or the like in contact with the gripping unit can be expected.

In a case in which the umbrella configured by the gripping unit 100 emits light having a peak wavelength in the visible light region, the umbrella can function as a light. Thus, when the user is walking on the road or the like at night while holding the umbrella, the user can become clearly visible and also can easily recognize a surrounding situation. The light emitting apparatus 1 or the lighting apparatus 10 may be located in a shaft or a rib of the umbrella. By arranging the light emitting apparatus 1 or the lighting apparatus 10 at various parts of the umbrella, the light emitting apparatus 1 or the lighting apparatus 10 can exhibit the antibacterial effect on the entire umbrella and, simultaneously, function as a light.

The parasol may be placed, for example, on a balcony or a porch of an apartment, or at a seat on a terrace of a store. In this case, the parasol can be used indoors or outdoors as a highly stylish interior. Further, the parasol can emit light that has high color rendering properties and makes the user feel comfortable in daily life. In this case, the parasol can improve the relaxing effect on the user who spends time eating on the balcony or the like.

As illustrated in FIG. 17, the gripping unit 100 may be configured as, for example, a floor on which the user can walk.

The floor configured by the gripping unit 100 may be installed in, for example, a bathroom of a general household, an accommodation facility including a hotel or an inn, an entertainment facility including a public bath or a shower room, or a bathroom or a large communal bath in a hospital or a nursing facility. The floor may be installed in a place where many users gather, including a gymnasium, a fitness gym, or a hall.

The floor configured by the gripping unit 100 exhibits the antibacterial effect by emitting light having a peak wavelength in the violet light region. Thus, bacteria and the like are suppressed from growing on the surface of the floor, even when numerous people walk on the floor. Bacteria and the like easily grow particularly in places that are liable to become wet such as a bathroom. By installing the floor configured by the gripping unit 100, bacteria and the like are suppressed from growing even in a place where they grow easily. As a result, the floor can be kept clean. Also, because the floor exhibits the antibacterial effect, bacteria are suppressed from being passed onto numerous people. Further, exhibition of the antibacterial effect against bacteria attached to the feet or the like of the user in contact with the floor can be expected. As a result, user's health can be maintained and illness precaution can be realized.

The floor may emit light having a peak wavelength in the visible light region. In this case, the floor can function as a light. The floor can be used as a highly stylish interior in a bathroom of a general household, an accommodation facility including a hotel or an inn, an entertainment facility including a public bath or a shower room, or a bathroom or a large communal bath of a hospital or a nursing facility. Further, the floor can be easily visible to the user in a dark room. The floor may emit light that has high color rendering properties and makes the users feel comfortable in daily life. In this case, the relaxing effect exhibited to the user who spends time in the place where the floor is installed can be improved.

The place to install the floor is not limited to the above examples. The floor configured by the gripping unit 100 may be installed in various places.

The gripping unit 100 according to the present embodiment can reduce bacteria and the like attached to the gripping portion 20 by including the light emitting apparatus 1 or the lighting apparatus 10 configured to emit light in the violet light region. The gripping unit 100 can function as a light when further includes the wavelength conversion member 6 configured to convert light in the violet light region into light having a peak wavelength in the visible light region. As a result, the gripping unit 100 that has the antibacterial effect, is very safe, and functions as a light having high color rendering properties can be realized.

The light emitting apparatus 1 or the lighting apparatus 10 may be removably attached to the gripping portion 20 that can be gripped by the user. Further, the light emitting apparatus 1 or the lighting apparatus 10 may be arranged at least at a position where the light emitting apparatus 1 or the lighting apparatus 10 can irradiate light to the gripping portion 20 that can be gripped by the user. The light emitting apparatus 1 or the lighting apparatus 10 may be arranged at a position to irradiate the gripping portion 20 with light from the inside. In a case in which the light emitting apparatus 1 or the lighting apparatus 10 is arranged at a position to irradiate the gripping portion 20 with light from the inside, the light emitting apparatus 1 or the lighting apparatus 10 can avoid direct contact by the user. As a result, the light emitting apparatus 1 or the lighting apparatus 10 and the gripping unit 100 can be very safe. The light emitting apparatus 1 or the lighting apparatus 10 may be arranged at a position to irradiate the gripping portion 20 with light from the outside. In a case in which the light emitting apparatus 1 or the lighting apparatus 10 is arranged at a position to irradiate the gripping portion 20 with light from the outside, attachment of the light emitting apparatus 1 or the lighting apparatus 10 to the gripping portion 20 is facilitated. As a result, the convenience of the light emitting apparatus 1 or the lighting apparatus 10 and the gripping unit 100 can be improved. For example, the light emitting apparatus 1 or the lighting apparatus 10 may be arranged at a position to irradiate the gripping portion 20 with light from above. For example, the light emitting apparatus 1 or the lighting apparatus 10 may be arranged at a position to irradiate the gripping portion 20 with light from below.

Although the above embodiments have been described based on the figures and the examples, it should be apparent to those skilled in the art that various modifications and alterations can be made without departing from the present disclosure. Accordingly, such modifications and alterations are to be included in the scope of the present disclosure. For example, a function or the like included in each element can be rearranged without logical inconsistency, such that a plurality of elements are combined together, or one element is subdivided.

The descriptions such as "first" and "second" used herein are identifiers for distinguishing the configuration. In the configuration distinguished by the descriptions of "first" and "second", such numbers can be interchanged. For example, the first peak wavelength and the second peak wavelength can interchange their identifiers: "first" and "second". The interchange is performed simultaneously. The configuration remains being distinguished after the interchange. The identifiers may be removed. The configurations from which the identifiers are removed may be distinguished by reference signs. The descriptions of the identifiers "first" and "second" alone should not be used as a ground that defines the order of the elements or as a ground that proves the presence of a smaller numbered identifier.

### REFERENCE SIGNS LIST

1 light emitting apparatus (2: substrate, 3: light emitting element, 4: frame, 5: sealing member, 6: wavelength conversion member, 60: light transmitting member, 61: first fluorescent body, 62: second fluorescent body)
10 lighting apparatus (11: housing, 12: circuit board, 13: translucent substrate, 21: body, 21a: bottom portion, 21b: support portion, 22: cover)
20 gripping portion
100 gripping unit
λ1 first peak wavelength
λx second peak wavelength

## Claims

1. A light emitting apparatus comprising:
a light emitting element configured to emit light specified by a spectrum having a peak wavelength in a wavelength range from 360 nm to 430 nm; and
a wavelength conversion member configured to convert at least a portion of light emitted by the light emitting element into light specified by a spectrum having a peak wavelength in a wavelength range from 360 nm to 780 nm,
wherein the light emitting apparatus is configured to emit illumination light including light that is not converted by the wavelength conversion member, from among light emitted by the light emitting element, and light that is converted by the wavelength conversion member, and
a total energy of light having a wavelength included in the wavelength range from 360 nm to 430 nm in the illumination light is between 3% and 18% of a total energy of light having a wavelength included in the wavelength range from 360 nm to 780 nm.

2. The light emitting apparatus according to claim 1,
wherein the illumination light is specified by a spectrum having a peak wavelength in a wavelength range from 400 nm to 410 nm.

3. The light emitting apparatus according to claim 1 or 2,
wherein a total energy of light having a wavelength included in a wavelength range from 430 nm to 500 nm in the illumination light is between 5% and 30% of the total energy of light having a wavelength included in a wavelength range from 360 nm to 780 nm.

4. The light emitting apparatus according to any one of claims 1 to 3,
wherein a half width of a spectrum having a peak wavelength in a wavelength range from 360 nm to 430 nm in the illumination light is between 8 nm and 24 nm.

5. The light emitting apparatus according to any one of claims 1 to 4,
wherein a total energy of light having a wavelength included in a wavelength range less than 360 nm in the illumination light is 2% or less of a total energy of light having a wavelength included in a wavelength range from 360 nm to 780 nm.

6. The light emitting apparatus according to any one of claims 1 to 5,
wherein a half width of a spectrum having a peak wavelength in a wavelength range from 430 nm to 500 nm in the illumination light is between 25 nm and 60 nm.

7. The light emitting apparatus according to any one of claims 1 to 6,
wherein an intensity of light having a wavelength included in a wavelength range from 360 nm to 430 nm in the illumination light is between 0.003 J/cm² and 18 J/cm² per hour.

8. The light emitting apparatus according to any one of claims 1 to 7,
wherein an irradiance of light having a wavelength included in a wavelength range from 360 nm to 400 nm in the illumination light is less than 10 W • m⁻².

9. The light emitting apparatus according to any one of claims 1 to 8,
wherein an irradiance of light having a wavelength included in a wavelength range from 360 nm to 430 nm in the illumination light is 33 W • m⁻² or less.

10. The light emitting apparatus according to any one of claims 1 to 9,
wherein a radiance of light having a wavelength included in a wavelength range from 430 nm to 500 nm in the illumination light is less than 100 W · sr⁻¹ · m⁻².

11. A lighting apparatus including a plurality of light emitting apparatuses,
wherein each of the plurality of light emitting apparatuses includes a light emitting element and a wavelength conversion member,
the light emitting element is configured to emit light specified by a spectrum having a peak wavelength in a wavelength range from 360 nm to 430 nm,
the wavelength conversion member is configured to convert at least a portion of light emitted by the light emitting element into light specified by a spectrum having a peak wavelength in a wavelength range from 360 nm to 780,
the lighting apparatus is configured to emit illumination light including light that is not converted by the wavelength conversion member, from among light emitted by the light emitting element of each of the plurality of light emitting apparatuses, and light that is converted by the wavelength conversion member of each of the plurality of light emitting apparatuses, and
a total energy of light having a wavelength included in the wavelength range from 360 nm to 430 nm in the illumination light is between 3% and 18% of a total energy of light having a wavelength included in the wavelength range from 360 nm to 780 nm.

12. The lighting apparatus according to claim 11,
wherein the illumination light is specified by a spectrum having a peak wavelength in a wavelength range from 400 mm to 410 m.

13. The lighting apparatus according to claim 11 or 12,
wherein a total energy of light having a wavelength included in a wavelength range from 430 nm to 500 nm in the illumination light is between 5% and 30% of a total energy of light having a wavelength included in a wavelength range from 360 nm to 780 nm.

14. The lighting apparatus according to any one of claims 11 to 13,
wherein a half width of a spectrum having a peak wavelength in a wavelength range from 360 nm to 430 nm in the illumination light is between 8 nm and 24 nm.

15. The lighting apparatus according to any one of claims 11 to 14,
wherein a total energy of light having a wavelength included in a wavelength range less than 360 nm in the illumination light is 2% or less of a total energy of light having a wavelength included in a wavelength range from 360 to 780 nm.

16. The lighting apparatus according to any one of claims 11 to 15,
wherein a half width of a spectrum having a peak wavelength in a wavelength range from 430 nm to 500 nm in the illumination light is between 25 nm and 60 nm.

17. The lighting apparatus according to any one of claims 11 to 16,
wherein an intensity of light having a wavelength included in a wavelength range from 360 nm to 430 nm in the illumination light is between 0.003 J/cm² and 18 J/cm² per hour.

18. The lighting apparatus according to any one of claims 11 to 17,
wherein an irradiance of light having a wavelength included in a wavelength range from 360 nm to 400 nm in the illumination light is less than 10 Wm⁻².

19. The lighting apparatus according to any one of claims 11 to 18,
wherein an irradiance of light having a wavelength included in a wavelength range from 360 nm to 430 nm in the illumination light is 33 W • m⁻² or less.

20. The lighting apparatus according to any one of claims 11 to 19,
wherein a radiance of light having a wavelength included in a wavelength range from 430 nm to 500 nm in the illumination light is less than 100 W · sr⁻¹ · m⁻².

21. The lighting apparatus according to any one of claims 11 to 20 to be used as an antibacterial light.

22. A gripping unit compri sing:
a gripping portion configured to be gripped by a user; and
a light emitting apparatus including a light emitting element configured to emit light specified by a spectrum having a peak wavelength in a wavelength range from 360 nm to 430 nm.

23. A gripping unit compri sing:
a gripping portion configured to be gripped by a user; and
a light emitting apparatus according to any one of claims 1 to 10 or a lighting apparatus according to any one of claims 11 to 21.

24. A lighting apparatus comprising at least one light emitting apparatus according to any one of claims 1 to 10.
